# EUROPEAN PATENT SPECIFICATION

(11) **EP 0 624 284 B1**
(45) Date of publication and mention of the grant of the patent: **30.06.1999**
(21) Application number: 93904756.9
(22) Date of filing: 28.01.1993
(51) Int. Cl.: H01S 3/19, H01S 3/085, H01S 3/25

(54) **TAPERED SEMICONDUCTOR LASER GAIN STRUCTURE WITH CAVITY SPOILING GROOVES**
MIT RESONATORBEGRENZENDEN NUTEN VERSEHENE KONISCHE VERSTÄRKUNGSANORDNUNG FÜR HALBLEITERLASER
STRUCTURE DE GAIN DE LASER A SEMI-CONDUCTEUR EVASEE, DOTEE DE RAINURES DEFLECTRICES DE LA CAVITE

(30) Priority: 31.01.1992 US 829778
(43) Date of publication of application: 17.11.1994
(73) Proprietor: MASSACHUSETTS INSTITUTE OF TECHNOLOGY, Cambridge, MA 02142-1324 (US)
(72) Inventor: WALPOLE, James, N., Concord, MA 01742 (US); KINTZER, Emily, S., Arlington, MA 02174 (US); CHINN, Stephen, R., Westford, MA 01886 (US); WANG, Christine, A., Bedford, MA 01730 (US); MISSAGGIA, Leo, J., Milford, MA 01757 (US)
(74) Representative: Greenwood, John David
(86) International application number: PCT/US93/00838
(87) International publication number: WO 93/15537

(56) References cited:
- EP-A- 0 214 866
- EP-A- 0 468 482
- JP-A- 2 278 781
- US-A- 3 467 906
- US-A- 4 389 567
- US-A- 4 563 765
- US-A- 4 713 821
- US-A- 4 744 089
- US-A- 4 942 366
- US-A- 4 942 585
- US-A- 5 031 183
- US-A- 5 084 892
- US-A- 5 157 544
- PATENT ABSTRACTS OF JAPAN vol. 15, no. 14 (E-1022) 11 January 1991 & JP-A-02 264 488 (MITSUBISHI ELECTRIC) 29 October 1990
- "High-Power and Fundamental-Mode Oscillating Flared SBA Lasers", K. SHIGIHARA, T. AOYAGI, S. HINATA, Y. NAGAI, Y. MIHASHI, Y. SEIWA, K. IKEDA and W. SUSAKI, Electronics Letters, 01 September 1988, Vol. 24, No. 18, pp. 1182-1183.
- "A GaInAsP/InP Tapered-Waveguide Semiconductor Laser Amplifier Integrated with a 1.5 mum Distributed Feedback Laser", P.A. YAZAKI, K. KOMORI, G. BENDELLI, S. ARAI and Y. SUEMATSU, IEEE Transactions Photonics Technology Letters, Vol. 3, No. 12, 12/XX/91, pp. 1060-1063, "A New Structure for High-Power TW-SLA", G. BENDELLI, K. KOMORI S. ARAI and Y, SUEMATSU, IEEE Photonics Technology Letters, Vol. 3, No. 1, 01/XX/91, pp. 42-44.
- TSANG et al., Appl. Phys. Lett., Vol. 38, No. 3, pp. 120-201, February 1981.
- WILCOX et al., STS Press, Mclean, Va., TRW Space Tech. Group, pp. 386-90, 1986, Abstract only provided.
- NOLTING et al., Heinrich-Hertz-Inst. fuer Nachrichtentech, Vol. 45, No. 5-6, pp. 30-40, 5-6/91, Abst. only.

## Description

### Field of the Invention

The invention pertains to semiconductor laser amplifiers. More particularly, the invention pertains to semiconductor laser amplifiers having tapered amplification regions.

### Background of the Invention

Semiconductor laser oscillators (i.e., laser light sources, hereinafter lasers) and semiconductor laser amplifiers (i.e., hereinafter amplifiers) were first developed in the 1960s. Such laser oscillators and amplifiers offered the obvious advantage of extremely small size over the other types of lasers. (A typical semiconductor amplifier may be on the order of few hundred micrometers long). These first semiconductor lasers were fabricated of a single type of semiconductor.

A modern semiconductor laser oscillator or amplifier typically comprises a semiconductor heterostructure, that is, it is made from more than one semiconductor material such as gallium arsenide (GaAs) and aluminum gallium arsenide (AlGaAs).

A modern semiconductor laser oscillator or amplifier typically comprises a semiconductor heterostructure, that is, it is made from more than one semiconductor material such as gallium arsenide (GaAs) and aluminum gallium arsenide (AlGaAs). Semiconductor oscillators and amplifiers are made from a combination of semiconductor materials which have different bandgap energies in order to achieve electrical current confinement as well as different optical indices of refraction in order to achieve optical confinement.

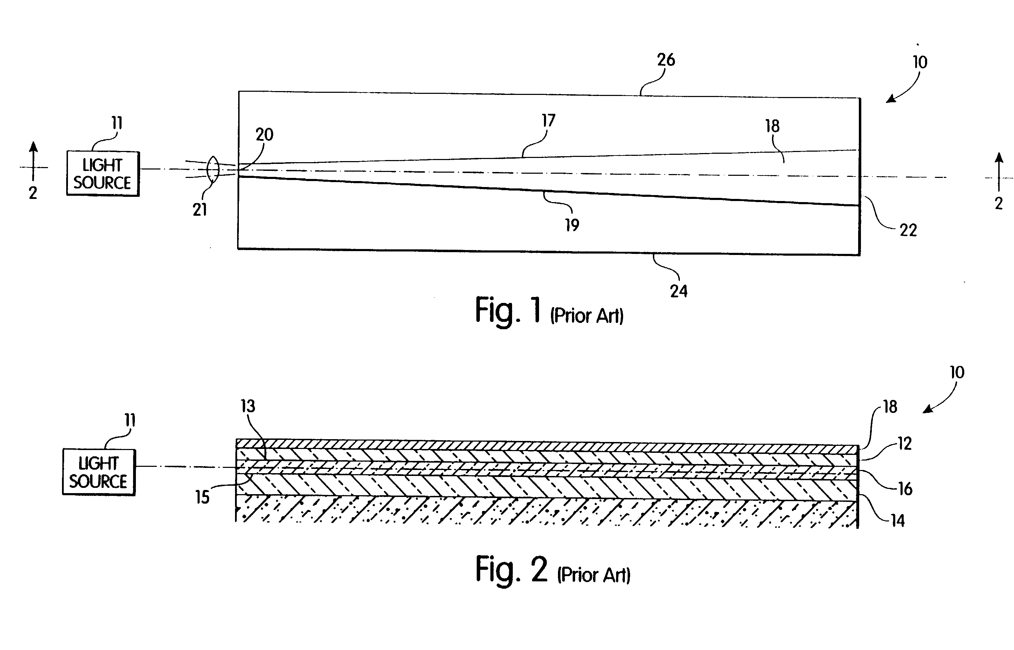

An exemplary double heterostructure amplifier 10 of the prior art is illustrated in FIGS. 1 and 2 and comprises three layers of semiconductor material; 1) a p-type material 12 with a relatively high bandgap, such as AlGaAs, 2) an n-type material 14 with relatively high bandgap, which may also be AlGaAs, and 3) a relatively low bandgap p-type material 16, such as GaAs, sandwiched between the ocher two layers. A metal contact 18 is placed in contact with the top surface of the top layer, which may be either the n-type or p-type high bandgap material. When sufficient current is passed through the metal contact, electrons and holes are injected into the active region 16 from the high bandgap material layers 12 and 14. These electrons and holes are trapped in the potential well created by the low band gap GaAs material. Since the electrons are trapped in the active region 16, they are forced to combine with each other in the GaAs material . Light introduced into this region will be amplified.

Confinement of the light to the GaAs layer 16 is provided by the wave guide properties of the AlGaAs/GaAs/AlGaAs material structure. The AlGaAs layers have a lower optical index of refraction than that of the GaAs material thus providing total internal reflection of light off of the junctions 13 and 15 so that the light remains within the GaAs layer 16. The electrical contact 18 defines the lateral boundaries 17 and 19 of the amplification region.

Many approaches have been proposed to achieve the goal of high-powered, continuous-wave operation with a single-lobed spatial mode output from semiconductor lasers or semiconductor amplifiers. One such approach is to employ a laterally tapered electrical contact 18 so as to define a laterally tapered amplification region such as is illustrated by FIG. 1. In operation, light generated by a laser 11 is focused by a lens 21 on the input facet 20 of tapered amplifier 10. The use of a tapered amplification region allows for greater gain before saturation than non-tapered amplifier structures because it permits a single-spatial-mode beam entering at the input facet 20 to expand with nearly free diffraction as it propagates through the semiconductor. If the beam is allowed to spread naturally without any external interference, the beam will spread in its lowest Gaussian mode, thus leading to the desired spatially uniform amplified output beam. Also, since the beam expands as it increases in power, gain saturation is reduced. Further, the expansion of the beam reduces the possibility of optical damage at the output facet 22 because the power in the beam is more spread out.

The tapered amplification region structure, however, has a drawback in that such a structure is easily susceptible to self-oscillation. Self-oscillation occurs when a small portion of the light striking the output facet is reflected back into the semiconductor medium. The reflected light interferes with the input light as it propagates down the semiconductor causing non-uniformity in the gain profile as well as in the spatial distribution of the output light and possibly even temporal instability of the output light.

In semiconductor lasers, well defined and controlled self-oscillation is desirable and, in fact, necessary in order to achieve lasing. However, uncontrolled self-oscillation is unnecessary and therefore undesirable. Further, in semiconductor amplifiers, any self-oscillation is unnecessary and therefore undesirable since it interferes with the input light and causes the generation of higher order spatial distribution modes (i.e., mode conversion) leading to non-uniformity in the spatial distribution of the beam. It also reduces gain. Self-oscillation can also lead to temporal instability of the output beam.

This problem can be partially alleviated by using anti-reflection coatings on the input and output facets 20 and 22. However, this solution is often difficult to achieve in practice and, in fact, may be impossible to incorporate in certain monolithic implementations where a semiconductor master oscillator laser and a semiconductor amplifier are integrated on the same chip.

Accordingly, it is an object of the present invention to provide an improved semiconductor laser amplifier.

It is a further object of the present invention to provide a tapered semiconductor amplifier with increased ability to suppress self-oscillation.

It is another object of the present invention to provide an improved tapered semiconductor laser amplifier with improved ability to suppress mode conversion.

It is yet another object of the present invention to provide an improved semiconductor laser oscillator. It is one more object of the present invention to provide a semiconductor gain structure that can be used as a laser oscillator or as a laser amplifier depending on the application of anti-reflection coating to the input facet of the structure.

EP-A-0 214 866 discloses a semiconductor laser device comprising a multi-layered semiconductor crystal containing an active region for laser oscillation, wherein the extended portions of the active region which are adjacent to both sides of one facet having the width of a selected value of said device constitute light-absorbing regions by which light in a high-order transverse mode is absorbed to a greater extent than that in a fundamental transverse mode, thereby achieving laser oscillation in a stable fundamental transverse mode up to a high output power.

EP-A-0 468 428 discloses a buried heterostructure type distributed feedback semiconductor laser which comprises a semiconductor substrate transparent to an oscillation light beam, a laser stripe including a diffraction grating, an active layer and a guiding layer formed on the semiconductor substrate, and semiconductor peripheral region formed so as to cover the laser stripe on the semiconductor substrate. The semiconductor peripheral region is transparent to an oscillation light beam. Rectangular grooves are formed near both sides of emission facet of the laser stripe more deeply than the laser stripe. Since a radiation mode from the laser stripe is reflected and scattered by the grooves, it cannot hardly reach the emission facet. Therefore, the radiation mode does not interfere with an output beam from the laser.

JP-A-2,264,488 discloses a semiconductor laser gain structure according to the preamble of claim 1.

The present invention is characterised by the features of the characterising portion of claim 1.

### Summary of the Invention

The invention comprises a tapered semiconductor gain structure which can be utilized as a semiconductor laser amplifier or a semiconductor laser oscillator.

The invention comprises a semiconductor gain structure employing a tapered gain region between cleaved input and output facets. The lateral dimension of the gain region of the semiconductor is defined by a tapered electrical metal contact on the surface of the semiconductor. A wave guiding layer is constructed by conventional layering of semiconductor materials. Light of a fundamental Gaussian spatial distribution mode which is focused onto the input facet adjacent the gain region propagates freely down the tapered gain region expanding in its fundamental Gaussian mode and gaining in power. There is no intentionally imposed refraction index gradient at the boundary of the gain region. The gain region is defined solely by the electrical contact. Accordingly, the amount of light reaching the gain structure boundary which is reflected back into the gain structure is minimized, thereby reducing interference between reflected light and the amplified input light and generation of higher order spatial distribution modes.

Further, two reflective cavity spoiling grooves are etched in the semiconductor adjacent the input facet with a gap provided therebetween so that the input light can pass through and propagate down the gain region of the semiconductor. The grooves are positioned so as to receive the majority of light which reflects off of the output facet back into the semiconductor and are angled to reflect that light away from the gain region and primarily into the substrate or the saw-cut lateral edges. Accordingly, undesirable self-oscillation is significantly reduced since the majority of the light which is reflected back from the output facet is directed by the etched grooves away from the gain region.

When the device is used as a laser amplifier, both the input and output facets are anti-reflection coated.

However, when the device is used as a laser oscillator, only the output facet is anti-reflection coated. Thus, a relatively large portion of the light which is reflected off of the center of the output facet back towards the input facet between the cavity spoiling grooves is again reflected back into the semiconductor cavity resulting in oscillation. The light reflected off of the non-central part of the output facet is not returned to the input facet, but strikes the spoiling grooves and is directed thereby away from the gain region. By virtue of oscillating only the light striking the centermost portion of the output facet, oscillation of higher order spatial distribution modes is suppressed.

### Brief Description of the Drawings

FIG. 1 is a plan view of a tapered gain structure laser amplifier of the prior art.

FIG. 2 is a cross-sectional view taken along line 2-2 of FIG. 1.

FIG. 3 is a plan view of the semiconductor gain structure of the present invention configured as a laser amplifier.

FIG. 4 is a cross-sectional view taken along line 4-4 of FIG. 3.

FIG. 5 is a plan view of a second embodiment of the semiconductor structure of the present invention configured as a laser oscillator.

FIG. 6 is an illustration of exemplary light distributions of light traveling in the laser oscillator of FIG. 5.

### Detailed Description of the Invention

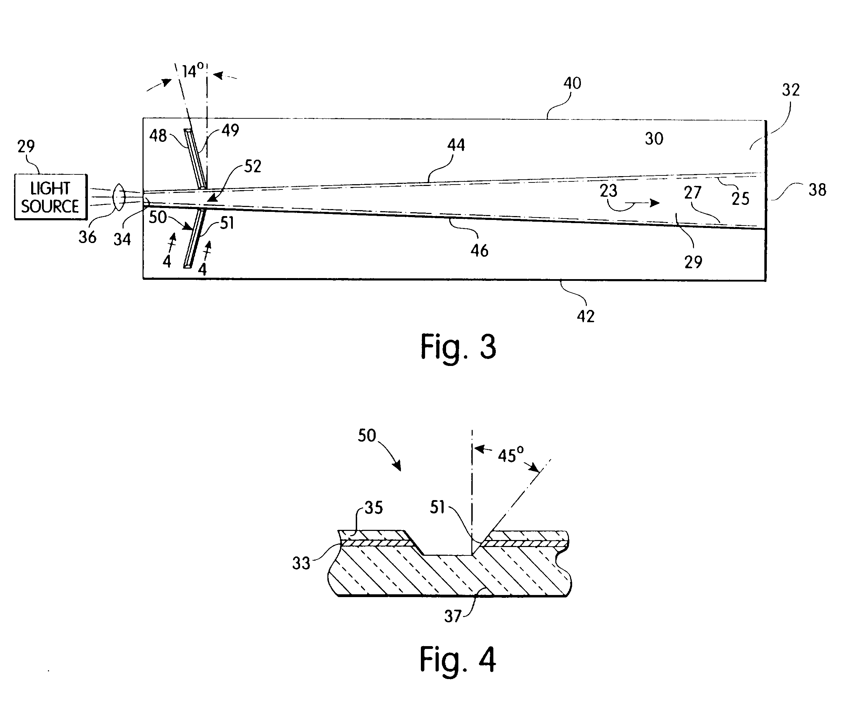

FIG. 3 is a plan view of the semiconductor laser amplifier of the present invention. FIG. 4 is a cross-sectional view taken along line 4-4 of FIG. 3. The semiconductor layer structure is somewhat conventional for heterostructure semiconductor lasers and amplifiers in that it comprises a layer of low bandgap material sandwiched between two layers of oppositely doped high bandgap material. A tapered electrically conductive contact 30 is placed on the surface 32 of the semiconductor structure. Contact 30 may be metal. Light from a laser light source 29 is introduced to cleaved input facet 34 through focusing lens 36. The degree of taper is selected so as to allow the input beam to spread naturally in its fundamental Gaussian spatial mode such that its light intensity profile has no nulls when it reaches the cleaved output facet 38. The lateral edges 40 and 42 of the semiconductor are saw-cut. No intentional gradient in the index of refraction of the material is imposed at the boundaries 44 and 46 of the gain region. The boundaries 44 and 46 are defined solely by conductive metal contact 30. Reflective cavity spoiling grooves 48 and 50 are etched through the waveguide layer at positions selected to receive light reflected off of the output facet 38 before it is returned to the input facet 34. The grooves are etched at an angle such that they reflect the light away from the gain region. A gap 52 is provided between the grooves 48 and 50 to allow the input light to propagate between the grooves down the gain region. In the preferred embodiment, the grooves are angled at 14° from the plane parallel to the output facet 38 and 45° from the plane of the waveguide layer as shown in FIG. 4.

When the gain structure is utilized as an amplifier, both the input facet 34 and the output facet 38 are coated with an anti-reflection coating so as to minimize reflection off of these cleaved surfaces. Nevertheless, some light is reflected off of the output facet 38 and returned into the semiconductor towards the input facet 34. The majority of such light will strike the cavity spoiling grooves 48 and 50 whereupon it will be reflected off of the etched grooves either towards the saw-cut edges 40 and 42 and out of the semiconductor or down into the substrate (not shown). The small amount of light which passes through the gap 52 between the grooves strikes the input facet which is also coated with an anti-reflective coating. Accordingly, since the majority of light reflected off of output facet 38 strikes the cavity spoiling grooves, the amount of light which can oscillate within the semiconductor is significantly reduced.

By having the smallest possible index gradient at the boundaries 44 and 46 of the gain region, excitation of high-order index-guided modes is substantially eliminated. Such modes would tend to be dispersive and to create extra phase variations across the beam. The spatial beam quality would, in turn, be deteriorated.

However, since there is no intentionally imposed refractive index gradient at the boundaries, most of the light which strikes the boundary simply passes through it rather than being reflected back into the gain region. A small amount of index guiding may be unavoidable due to thermal effects caused by the current flowing through the contact patch 30 as well as gain saturation effects and strain effects. Nevertheless, these effects would only cause a small fraction of the output power to fall outside of the main spatial mode.

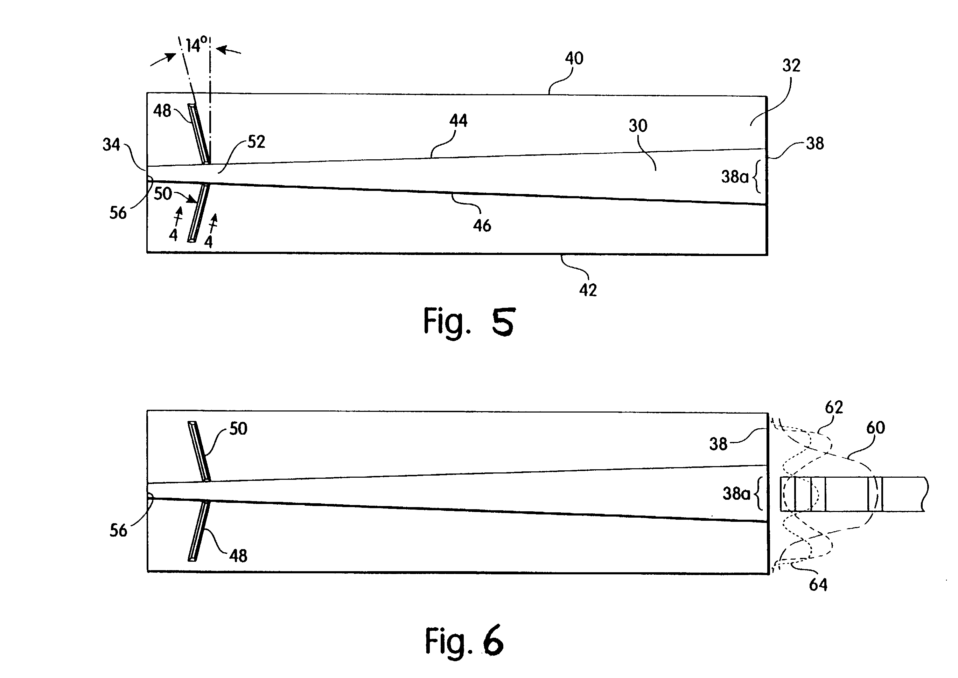

The gain structure disclosed herein may also be modified for use as a laser oscillator, i.e., a laser light source. FIG. 5 is a plan view of the gain structure of the present invention modified to achieve a controlled self-oscillation in the fundamental Gaussian spatial mode so as to achieve lasing action. In FIG. 5, like features are indicated with the same reference numerals as in FIG. 3. The structure is essentially identical to the FIG. 3 embodiment except that input facet 56 is not coated with an anti-reflection coating. Accordingly, a significantly greater portion of the light reflected off of the output facet which is returned between the cavity spoiling grooves to the input facet 56 is reflected back into the semiconductor. Accordingly, a significantly large amount of self-oscillation is allowed so that lasing may occur.

The employment of the etched grooves in this configuration as an oscillator leads to an extremely stable fundamental Gaussian oscillation. As previously explained, the majority of the light which is reflected off of the output facet strikes the etched grooves and is directed out of the semiconductor. Only the portion of the light which strikes the output facet very close to its center, as illustrated at 38a in FIG. 5, can pass through the gap 52 between the etched grooves 48 and 50 and strike the input facet 56. As illustrated in FIG. 6, the vast majority of light which strikes the center 38a of the output facet 38 is very uniform in intensity thus leading to superior suppression of high order spatial distribution modes. Curve 60 in FIG. 6 illustrates an exemplary spatial light intensity distribution of light propagating in the gain region in the fundamental Gaussian mode. Dashed curve 62 and dotted curve 64 illustrate the spatial light intensity distribution of light propagating in the gain region in the second and third harmonics of the fundamental. The relative intensities of the various harmonics are not accurate. As previously discussed, the present invention substantially reduces generation of higher order spatial modes. However, the second and third order harmonics are shown enlarged for ease of illustration. As can be seen by the juxtaposition of curve 60 with the center portion 38a of the output facet 38, an extremely flat portion of the light intensity distribution curve of the fundamental harmonic 60 strikes the output facet in the center region 38a (i.e., the portion which will be returned to input facet 56 for oscillation). It can also be seen with respect to the second and third harmonics shown by curves 62 and 64 that the light intensity distribution in region 38a is not as uniform as curve 60 and is of much lower power than curve 60. Accordingly, higher spatial mode suppression is achieved for two primary reasons. First, a much lower amount of light energy in the higher harmonics is returned to the input facet 56. Second, the light of the fundamental Gaussian spatial mode which is returned to the input facet is extremely uniform in intensity because the flatest portion of the light distribution curve strikes region 38a of the output facet 38. Accordingly, oscillation of light of extremely uniform light distribution occurs thus leading to superior suppression of high order distribution harmonics.

The gain structure disclosed herein was implemented as a laser amplifier. Total continuous wave output power in excess of 1.2 watts with 1.0 watts contained in a single-lobed spatial mode was achieved.

In this implementation, the reflective cavity spoiling grooves were fabricated by a reactive ion etching (RIE) process with the use of an oxide etch mask. The RIE system was operated at 28 mTorr pressure with a H₂:CH₄ plasma established by a 4:1 gas-flow ratio and an rf power of 0.9 watts/cm². The wafer was then coated with 300 nm of SiO₂. The linearly tapered contact pad was formed using photolithography to open the tapered pattern in the oxide. Metals (Ti/Au) were evaporated over the entire wafer making ohmic contact to the tapered region. The semiconductor amplifier was fabricated from InGaAs/AlGaAs graded-index separate-confinement heterostructure single-quantum-well semiconductor material. This type of strained-layer quantum well material has been shown to be inherently more reliable than conventional unstrained GaAlAs material. The device was 2 mm long and 200 µm wide at the broadest part of the taper. The input and output facets were cleaved and anti-reflection coated with a quarter-wave layer of SiOₓ, where x is adjusted to give an index near 1.8, with a residual reflectivity estimated to be approximately 1%. The wavelength of operation for this embodiment was 970 nm.

The invention may also be implemented utilizing back-biased junctions instead of the etched grooves. The back-biased junctions form absorbing regions that are difficult to optically saturate. It may also be possible to use other spoilers, such as long regions of proton-bombarded material or other absorbing schemes, and other techniques to deflect the beam out of the cavity.

Using the inventive gain structure disclosed herein as a high power unstable oscillating laser rather than an amplifier by applying the anti-reflection coating only to the output facet, an output power of 1.5 watts continuous has been achieved with far-field intensity distribution superior to that of high-power laser arrays which operate in the out-of-phase mode.

The inventive gain structure disclosed herein has wide applications. Depending on the composition of the strained layer semiconductor material, the amplifiers can be made to operate at wavelengths ranging from 0.8 to 1.0 µm. Accordingly, the present invention can be used as an amplifier or as an unstable oscillator suitable for pumping rare-earth doped fiber amplifiers where high-spatial mode quality is required. In addition, these devices can be used in other pumping applications such as solid-state laser pumps, and particularly as end pumps. Since high spectral purity and high modulation rates can be achieved by controlling the master oscillator characteristics, these amplifiers can be used to build high-powered transmitters for free-space optical communication systems.
High-powered defraction-limited diode source applications are also possible for efficient frequency-doubling in the blue-green region of the spectrum for optical-disk-memory and other applications.

Having thus described a few particular embodiments of the invention, various alterations, modifications and improvements will readily occur to those skilled in the art. Such alterations, modifications and improvements as are made obvious by this disclosure are intended to be part of this description though not expressly stated herein, and are intended to be within the scope of the invention. Accordingly, the foregoing description is by way of example only, and not limiting, the invention being as defined in the following claims.

## Claims

1. A semiconductor laser gain structure comprising:
a section of semiconductor material having first and second facets (34,38) at longitudinally opposite ends thereof, a top surface, and a wave guiding structure including an active layer (16) of low bandgap material being sandwiched between two layers of oppositely doped high bandgap material (12,14), in which wave guiding structure electromagnetic radiation travels longitudinally
an electrically conductive contact pad (30) joined to said top surface of said section of semiconductor material and extending longitudinally from said second facet (38) towards said first facet (34), said electrically conductive contact pad (30) being tapered such that said pad (30) is wider at said second facet (38) than towards said first facet (34), the portion of said wave guiding structure which is beneath said pad (30) comprising a gain region in said wave guiding structure, characterised in that:
the lateral dimension of the gain region is defined solely by the tapered pad (30), and the semiconductor laser gain structure further comprises two cavity spoiling means (48,50) in said wave guiding structure positioned outside of and on opposite sides to said gain region and at the narrow end of the gain region such that said cavity spoiling means (48,50) receive in operation a portion of the electromagnetic radiation which is reflected off of said second facet (38) back into said section of semiconductor material, said cavity spoiling means (48,50) being adapted to remove said portion of electromagnetic radiation which it receives from said section of semiconductor material, which spoiling means (48,50) either comprises reflective surfaces or light absorbing reverse biased junctions or light absorbing regions formed in said wave guiding structure.

2. A semiconductor laser gain structure as set forth in claim 1, wherein said cavity spoiling means (48,50) comprise grooves etched in to said wave guiding structure, grooves defining said reflective surfaces which reflect said received light away from said gain region.

3. A semiconductor laser gain structure as set forth in claim 1, wherein said reflective surface of said cavity spoiling means (48,50) is positioned at a 14 degree angle from a plane parallel to said second facet (38).

4. A semiconductor laser gain structure as set forth in claim 3, wherein said reflective surface of said cavity spoiling means (48,50) is positioned at a 45 degree angle from a plane parallel to said top surface.

5. A semiconductor laser gain structure as set forth in any preceding claim, wherein said section of semiconductor material further comprises first and second saw-cut lateral faces connecting longitudinally said first and second facets (34,38) and being opposite to each other.

6. A semiconductor laser gain structure as set forth in any preceding claim, wherein said gain structure is a laser amplifier and said gain structure further comprises anti-reflection coatings on said first and second facets (34,38) and electrically conductive contact pad (30) is linearly tapered at a degree such that said gain region is large enough to allow electromagnetic radiation propagating towards said second facet (38) to expand in a diffraction limited single-lobed beam within said gain region.

7. A semiconductor laser gain structure as set forth in claims 1 to 5, wherein said gain structure is a laser oscillator and said second facet (38) is anti-reflection coated.

8. A semiconductor laser gain structure as set forth in any preceding claim in which the waveguiding structure is adapted such that the refractive index gradient at the boundaries of the gain region is minimised.

## Patentansprüche

1. Halbleiterlaser-Verstärkungsanordnung, aufweisend:
einen Abschnitt eines Halbleitermaterials mit ersten und zweiten Kristallflächen (34, 38) an dessen längsseitig gegenüberliegenden Enden, eine Oberseite und eine Wellenleitungsanordnung, die eine aktive Schicht (16) aus einem Material mit niedrigem Bandabetand, das zwischen zwei Schichten (12, 14) eines entgegengesetzt dotierten Materials mit hohem Bandabstand eingeschlossen ist, umfaßt, wobei in dieser Wellenleitungsanordnung elektromagnetische Strahlung in Längsrichtung wandert;
eine elektrisch leitende Kontaktfläche (30) die mit der Oberseite des Abschnittes aus Halbleitermaterial verbunden ist und sich in Längsrichtung von der zweiten Kristallfläche (38) zu der ersten Kristallfläche (34) erstreckt, wobei die elektrisch leitende Kontaktfläche (30) sich verjüngt, so daß die Kontaktfläche (30) bei der zweiten Kristallfläche (38) breiter als bei der ersten Kristallfläche (34) ist, und der Abschnitt der Wellenleitungsanordnung, welcher sich unterhalb der Fläche (30) befindet, einen Verstärkungsbereich in der Wellenleitungsanordnung aufweist, dadurch gekennzeichnet, daß:
die seitliche Abmessung des Verstärkungsbereich lediglich durch die sich verjüngende Fläche (30) definiert wird, und die Halbleiterlaser-Verstärkungsanordnung weiterhin zwei Hohlraumableitungseinrichtungen (48, 50) in der Wellenleitungsanordnung so außerhalb und an gegenüberliegenden Seiten des Verstärkungebereiche und an dem schmalen Ende des Verstärkungsbereichs positioniert aufweist, daß die Hohlraumableitungseinrichtungen (48, 50) im Betrieb einen Anteil der elektromagnetischen Strahlung aufnehmen, welcher von der zweiten Kristallfläche (38) in den Abschnitt des Halbleitermaterials reflektiert wird, wobei die Hohlraumableitungseinrichtungen (48, 50) dafür angepaßt sind, den Anteil der elektromagnetischen Strahlung zu entfernen, welchen sie von dem Abschnitt des Halbleitermaterials empfangen, wobei die Ableiteinrichtungen (48, 50) entweder reflexive Oberflächen oder lichtabsorbierende rückwärts vorgespannte Übergänge oder lichtabsorbierende Abschnitte, die in der Wellenleitungsanordnung ausgebildet sind, aufweisen.

2. Halbleiterlaser-Verstärkungsanordnung nach Anspruch 1, wobei die Hohlraumableitungseinrichtungen (48, 50) in die Wellenleitungsanordnung geätzte Nuten aufweisen, und die Nuten die reflexiven Oberflächen definieren, welche das empfangene Licht von dem Verstärkungsbereich weg reflektieren.

3. Halbleiterlaser-Verstärkungsanordnung nach Anspruch 1, wobei die reflexive Oberfläche der Hohlraumableitungseinrichtungen (48, 50) in einem Winkel von 14 Grad zu einer Ebene parallel zu der zweiten Kristallfläche (38) positioniert ist.

4. Halbleiterlaser-Verstärkungsanordnung nach Anspruch 3, wobei die reflexive Oberfläche der Hohlraumableitunsseinrichtungen (48, 50) in einem Winkel von 45 Grad zu einer Ebene parallel zu der Oberseite positioniert ist.

5. Halbleiterlaser-Verstärkungsanordnung nach einem der vorstehenden Ansprüche, wobei der Abschnitt des Halbleitermaterials erste und zweite sägegeschnittene Seitenflächen aufweist, welche in Längsrichtung die ersten und zweiten Kristallflächen (34, 38) verbinden und einander gegenüberliegen.

6. Halbleiterlaser-Verstärkungsanordnung nach einem der vorstehenden Ansprüche, wobei die Verstärkungsanordnung ein Laserverstärker ist und die Verstärkungsanordnung ferner Antireflexionsbeschichtungen auf den ersten und zweiten Kristallflächen (34, 38) aufweist und die elektrisch leitende Kontaktfläche (30) in einem in einem Maß sich linear verjüngt, so daß der Verstärkungsbereich groß genug ist, um das Expandieren einer auf die zweite Kristallfläche (38) zu wandernden elektromagnetischen Strahlung in einen beugungebegrenzten einkeuligen Strahl innerhalb des Verstärkungsbereichs zu ermöglichen.

7. Halbleiterlaser-Verstärkungsanordnung nach einem der vorstehenden Ansprüche 1 bis 5, wobei die Verstärkungsanordnung ein Laseroszillator ist und die zweite Kristallfläche (38) antireflexionsbeschichtet ist.

8. Halbleiterlaser-Verstärkungsanordnung nach einem der vorstehenden Ansprüche, in welcher die Wellenleitungsanordnung so angepaßt ist, der Gradient des Brechungsindexes an den Grenzen des Verstärkungsbereichs minimiert ist.

## Revendications

1. Structure à gain, de laser semi-conducteur, comprenant :
un tronçon de matériau semi-conducteur ayant des première et seconde facettes (34, 38) a ses extrémités opposées en direction longitudinale, une surface supérieure, et une structure de guidage d'ondes comportant une couche active (16) de matériau ayant une bande interdite de faible hauteur en sandwich entre deux couches de matériau ayant une bande interdite de grande hauteur dopées de manière opposée (12, 14) dans laquelle un rayonnement électromagnétique de structure de guidage d'ondes se propage longitudinalement,
une plaquette (30) de contact électriquement conductrice assemblée à ladite surface supérieure dudit tronçon de matériau semi-conducteur et s'étendant longitudinalement de ladite seconde facette (38) vers ladite première facette (34), ladite plaquette (30) de contact électriquement conductrice étant biseautée de telle sorte que ladite plaquette (30) est plus large à l'emplacement de ladite seconde facette (38) que vers ladite première facette (34), la partie de ladite structure de guidage d'ondes qui est en dessous de ladite plaquette (30) comprenant une région de gain dans ladite structure de guidage d'ondes, caractérisée en ce que :
la dimension latérale de la région de gain est définie uniquement par la plaquette (30) biseautée, et la structure à gain de laser semi-conducteur comprend en outre deux moyens (48, 50) de déflexion de cavité dans ladite structure de guidage d'ondes positionnés à l'extérieur de et sur des faces opposées de ladite région de gain et à l'extrémité étroite de la région de gain de telle sorte que les moyens (48, 50) de déflexion de cavité reçoivent en fonctionnement une partie du rayonnement électromagnétique qui est réfléchi par ladite seconde facette (38) dans ledit tronçon de matériau semi-conducteur, lesdits moyens (48, 50) de déflexion de cavité étant adaptés pour écarter ladite partie de rayonnement électromagnétique qu'ils reçoivent dudit tronçon de matériau semi-conducteur, lesquels moyens (48, 50) de déflexion soit comprennent des surfaces de réflexion ou des jonctions polarisées en inverse d'absorption de lumière ou des régions d'absorption de lumière formées dans ladite structure de guidage d'ondes.

2. Structure à gain, de laser semi-conducteur, selon la revendication 1, dans laquelle lesdits moyens de déflexion (48, 50) de cavité comprennent des rainures gravées dans ladite structure de guidage d'ondes, rainures définissant lesdites surfaces de réflexion qui réfléchissent ladite lumière reçue au loin de ladite région de gain.

3. Structure à gain, de laser semi-conducteur, selon la revendication 1, dans laquelle ladite surface de réflexion desdits moyens de déflexion (48, 50) de ladite cavité est positionnée à un angle de 14° par rapport à un plan parallèle à ladite seconde facette (38).

4. Structure à gain, de laser semi-conducteur, selon la revendication 3, dans laquelle ladite surface de réflexion desdits moyens de déflexion (48, 50) de ladite cavité est positionnée à un angle de 45° par rapport à un plan parallèle à ladite surface supérieure.

5. Structure à gain, de laser semi-conducteur, selon l'une quelconque des revendications précédentes, dans laquelle ledit tronçon de matériau semi-conducteur comprend en outre des première et deuxième faces latérales à trait de scie reliant longitudinalement lesdites première et seconde facettes (34, 38) et opposées l'une à l'autre.

6. Structure à gain, de laser semi-conducteur, selon l'une quelconque des revendications précédentes, dans laquelle ladite structure à gain est un amplificateur laser et ladite structure à gain comprend en outre des revêtements antireflet sur lesdites première et seconde facettes (34, 38) et une plaquette (30) de contact électriquement conductrice est biseautée linéairement à un degré tel que ladite région de gain est suffisamment large pour permettre une propagation d'un rayonnement électromagnétique vers ladite seconde facette (38) pour s'étendre en un faisceau à lobe unique limité en diffraction à l'intérieur de ladite région à gain.

7. Structure à gain, de laser semi-conducteur, selon les revendications 1 à 5, dans laquelle ladite structure à gain est un oscillateur laser et ladite seconde facette (38) comporte un revêtement antireflet.

8. Structure à gain, de laser semi-conducteur, selon l'une quelconque des revendications précédentes, dans laquelle la structure de guidage d'ondes est adaptée de telle sorte que le gradient d'indice de réfraction aux limites de la région de gain est minimisée.
